Europäisches Patentamt

European Patent Office

Office européen des brevets

(11) Veröffentlichungsnummer: **0 306 784**

**A2**

## (12) EUROPÄISCHE PATENTANMELDUNG

(21) Anmeldenummer: **88114002.4**

(51) Int. Cl.4: **G03F 7/10**

(22) Anmeldetag: **27.08.88**

(30) Priorität: **09.09.87 DE 3730213**

(43) Veröffentlichungstag der Anmeldung:
**15.03.89 Patentblatt 89/11**

(84) Benannte Vertragsstaaten:
**DE FR GB**

(71) Anmelder: **HOECHST AKTIENGESELLSCHAFT**
**Postfach 80 03 20**
**D-6230 Frankfurt am Main 80(DE)**

(72) Erfinder: **Herrmann, Heinz, Dr.**
**Am Güldenplan 15**
**D-6200 Wiesbaden(DE)**
Erfinder: **Billino, Susanne**
**Erfurter Strasse 1**
**D-6090 Rüsselsheim(DE)**

(54) **Vorsensibilisierte Druckplatte für den wasserlosen Flachdruck und Verfahren zu ihrer Herstellung.**

(57) Es wird eine vorsensibilisierte Druckplatte für den wasserlosen Flachdruck beschrieben, die aus einem Schichtträger, einer darauf aufliegenden Druckfarbe abweisenden vernetzten Silikonkautschukschicht, einer Zwischenschicht aus amorpher Kieselsäure oder aus einer belichteten Schicht einer lichtempfindlichen organischen Halogenverbindung und einer strahlungsempfindlichen Schicht besteht.

Die Zwischenschicht bewirkt eine bessere Haftung der lichtempfindlichen Schicht an der Silikonschicht und damit eine bessere Entwicklerresistenz und Druckauflage der Platte.

EP 0 306 784 A2

## Vorsensibilisierte Druckplatte für den wasserlosen Flachdruck und Verfahren zu ihrer Herstellung

Die Erfindung betrifft eine vorsensibilisierte Druckplatte für den wasserlosen Flachdruck, insbesondere Offsetdruck, sowie ein Verfahren zu ihrer Herstellung. Die erfindungsgemäße Druckplatte weist einen Schichtträger, eine Druckfarbe abweisende Schicht aus Silikongummi und eine äußere, strahlungsempfindliche Schicht auf.

Vorsensibilisierte Druckplatten für den wasserlosen Flachdruck sind bekannt, wobei die farbabstoßende Schicht über oder unter der lichtempfindlichen Schicht liegen kann. Wenn die lichtempfindliche Schicht als oberste Schicht angeordnet ist, hat die Platte den Vorteil, daß sie sich wesentlich leichter entwickeln läßt als im umgekehrten Fall; es ist wesentlich schwieriger, eine Platte mit einer farbabstoßenden Deckschicht, z. B. aus Silikongummi, durch Entfernen der entwicklerlöslichen Stellen der lichtempfindlichen Schicht und der darüberliegenden Stellen der Silikonschicht zu entwickeln. Gewöhnlich ist der Zusatz größerer Mengen organischer Lösemittel zum Entwickler oder überhaupt ein Entwickler auf Basis organischer Lösemittel und zumeist mechanische Unterstützung durch Reiben, Bürsten oder dgl. erforderlich. Der Entwickler wird durch die unlöslichen Silikongummipartikel verunreinigt und muß daher häufiger erneuert werden.

Trotz dieser bekannten Nachteile haben sich bisher in der Praxis hauptsächlich Platten mit einer Silikonschicht als oberster Schicht durchgesetzt. Das liegt u. a. an der Schwierigkeit, eine lichtempfindliche Schicht auf einer gehärteten Silikongummischicht haftfest zu verankern. Im Stand der Technik sind neben vielen Druckplatten dieser Schichtanordnung auch eine Reihe von Druckplatten für den wasserlosen Offsetdruck beschrieben, bei denen die lichtempfindliche Schicht die äußere Schicht ist.

In der DE-B 1 571 890 ist eine Trockenflachdruckplatte beschrieben, bei der auf eine gehärtete Silikonkautschukschicht ein Tonerbild oder eine lichtempfindliche Schicht aufgebracht wird, die durch Belichten und Entwickeln zum Druckfarbe annehmenden Bild verarbeitet wird. Gegebenenfalls wird auf die Silikonkautschukschicht eine vorgefertigte Metallschicht aufgepreßt und dann mit einer lichtempfindlichen Schicht versehen. Durch Belichten, Entwickeln und Ätzen wird ein oleophiles Bild auf der oleophoben Silikonschicht erzeugt. Ohne die Zwischenschicht werden nur geringe Druckauflagen erhalten, mit der relativ dicken Kupferzwischenschicht ist die Auflage hoch, jedoch läßt sich keine hohe Auflösung wie mit üblichen Offsetplatten erreichen.

In den DE-A 20 39 901 und 23 61 815 wird ein Verfahren zur Herstellung einer wasserlos druckenden Offsetplatte beschrieben, bei dem eine lichtempfindliche Schicht und eine ungehärtete Silikonkautschukschicht auf getrennten Schichtträgern hergestellt, dann laminiert und zur Härtung der Silikonschicht erhitzt werden. Das Verfahren ist umständlich und erfordert die Verwendung sehr eng begrenzter Materialien.

In der US-A 3 632 375 sind wasserlos druckende Flachdruckplatten beschrieben, die auf einer Silikongummischicht eine Verankerungsschicht und darauf eine lichtempfindliche Schicht tragen. Die Verankerungsschicht besteht aus zumeist wasserlöslichen Polymeren, die ggf. noch vernetzt werden. Die Verankerungsschichten und die lichtempfindlichen Schichten sind zumeist hydrophil und daher schlecht farbannehmend. Auch ist die Entwicklerresistenz dieser Materialien gering.

In der US-A 3 728 123 wird ein ähnliches Material beschrieben, bei dem die Zwischenschicht selbst lichthärtbar ist.

In der DE-B 24 49 172 ist eine vorsensibilisierte Flachdruckplatte für den wasserlosen Flachdruck beschrieben, die auf einer Silikonkautschukschicht eine photopolymerisierbare Schicht trägt. Ein ähnliches Material ist in der US-A 4 225 663 beschrieben.

Bei den bekannten Materialien zur Herstellung wasserlos druckender Flachdruckplatten, die auf der farbabweisenden Silikonschicht eine lichtempfindliche Schicht tragen, ist die Haftung zwischen diesen Schichten stets problematisch. Wird die Silikonschicht vor dem Aufbringen der lichtempfindlichen Schicht gehärtet bzw. vulkanisiert, so ist die Benetzung dieser Schicht erschwert und die Haftung besonders schlecht. Wird sie nach dem Aufbringen gehärtet, so besteht die Gefahr einer so haftfesten Verankerung von oleophilen Schichtteilen, daß beim Entwickeln diese Schichtteile nicht restlos entfernt werden und die Silikonschicht Farbe annimmt. Wenn zwischen beiden Schichten eine Verankerungsschicht vorgesehen ist, ist diese in ihrer Natur und Zusammensetzung den üblichen Bestandteilen, z. B. Bindemitteln, der lichtempfindlichen Schicht so ähnlich, daß auch hier analoge Probleme entstehen. Es ist insbesondere nach dem Stand der Technik nicht oder nur auf sehr umständliche Weise möglich, sehr dünne, hochauflösende lichtempfindliche Schichten so haftfest zu verankern, daß man durch einfaches Entwickeln hochaufgelöste, gut haftende Bildschablonen erhält, von denen sich hohe Auflagen drucken lassen.

In der älteren, nicht vorveröffentlichten deutschen Patentanmeldung P 36 28 719.9 (DE-A 36 28 719) ist eine vorsensibilisierte Druckplatte für den wasserlosen Flachdruck beschrieben, die auf einem Schichtträger eine lichtempfindliche Schicht, eine Zwischenschicht aus amorpher Kieselsäure und eine Deckschicht aus Silikongummi aufweist.

Aufgabe der Erfindung war es, eine vorsensibilisierte Druckplatte für den wasserlosen Flachdruck vorzuschlagen, die sich nach üblichen Verfahren einfach herstellen läßt, die sich mit im wesentlichen wäßrigen Lösungen ohne mechanische Unterstützung entwickeln läßt und die gut differenzierte, hochauflösende Druckschablonen mit hoher Druckauflagenleistung ergibt.

Erfindungsgemäß wird eine vorsensibilisierte Druckplatte für den wasserlosen Flachdruck mit einem Schichtträger, einer darauf aufliegenden Druckfarbe abweisenden vernetzten Silikonkautschukschicht, einer Zwischenschicht und einer strahlungsempfindlichen Schicht vorgeschlagen.

Die erfindungsgemäße Druckplatte ist dadurch gekennzeichnet, daß die Zwischenschicht aus amorpher Kieselsäure oder aus einer belichteten Schicht einer lichtempfindlichen organischen Halogenverbindung besteht.

Erfindungsgemäß wird ferner ein Verfahren zur Herstellung einer vorsensibilisierten Druckplatte für den wasserlosen Flachdruck vorgeschlagen, das dadurch gekennzeichnet ist, daß man auf einen Schichtträger eine Silikonkautschuklösung aufbringt und trocknet, auf die unvernetzte Silikonkautschukschicht nacheinander eine Zwischenschicht aus amorpher Kieselsäure und eine strahlungsempfindliche Schicht aufbringt und danach die Silikonkautschukschicht zu Silikongummi vernetzt.

Eine andere Ausführungsform des erfindungsgemäßen Verfahrens ·besteht darin, daß man auf einen Schichtträger eine Silikonkautschuklösung aufbringt und trocknet, auf die unvernetzte Silikonkautschukschicht eine Zwischen schicht aus einer lichtempfindlichen organischen Halogenverbindung aufbringt, die Zwischenschicht mit aktinischem Licht ohne Vorlage belichtet, dann eine strahlungsempfindliche Schicht aufbringt und danach die Silikonkautschukschicht zu Silikongummi vernetzt.

Die Vernetzung des Silikonkautschuks erfolgt durch thermische Vulkanisation. Diese kann bis zu einem gewissen Grad schon nach dem Aufbringen der Zwischenschicht, aber vor dem Aufbringen der strahlungsempfindlichen Schicht erfolgen. Sie wird dann nach dem Aufbringen der strahlungsempfindlichen Schicht vervollständigt. Die Vulkanisation wird unter Bedingungen durchgeführt, unter denen die temperaturempfindlichen strahlungs- bzw. lichtempfindlichen Schichten nicht geschädigt werden. Eine gute Vernetzung wird z. B. erreicht, wenn das Material wenige Minuten auf 100-120° C erwärmt wird.

Die Zwischenschichten verbessern nicht nur die Haftung der strahlungsempfindlichen Schicht auf der Silikonschicht, sondern auch die Benetzbarkeit der Silikonkautschukschicht durch die strahlungsempfindliche Beschichtungslösung.

Die Silikonkautschukschicht wird aus einer Lösung in einem unpolaren Lösungsmittel, z. B. aliphatischen oder aromatischen Kohlenwasserstoffen, aufgebracht. Grundsätzlich ist jeder Silikonkautschuk geeignet, der ausreichend farbabweisend ist, um ein Drucken im Offsetdruck ohne Feuchtwasser zu erlauben. Als "Silikon kautschuk" soll im Rahmen dieser Erfindung entsprechend der Definition von Noll, "Chemie und Technologie der Silikone", Verlag Chemie, 1968, S. 332, ein hochmolekulares, im wesentlichen lineares Diorganopolysiloxan bezeichnet werden, während für die vernetzten bzw. vulkanisierten Produkte die Bezeichnung "Silikongummi" verwendet wird. In jedem Fall wird eine Silikonkautschuklösung auf den Schichtträger aufgebracht und getrocknet.

Als Silikonkautschuke sind kalthärtende Einkomponenten- und bei niedriger Temperatur vernetzende Mehrkomponententypen geeignet, wie sie z. B. in den DE-A 23 50 211, 23 57 871 und 23 59 102 beschrieben sind. Die Einkomponenten-Silikonkautschuke basieren auf Polysiloxanen, die z. B. endständige Acetyl-, Oxim-, Alkoxy- oder Aminogruppen oder Wasserstoffatome enthalten. Im übrigen besteht das Polysiloxan im wesentlichen aus einer Dimethylpolysiloxankette. Die Methylgruppen können in geringerem Umfang auch durch andere Alkylgruppen, durch Halogenalkylgruppen oder substituierte oder unsubstituierte Arylgruppen ersetzt sein. Die endständigen funktionellen Gruppen sind leicht hydrolysierbar und härten bei Feuchtigkeitseinwirkung innerhalb von einigen Minuten bis Stunden bei Raumtemperatur aus (RTV-1-Silikonkautschuke).

Die Mehrkomponenten-Silikonkautschuke können durch Addition oder durch Kondensation vernetzbar sein. Die additionsvernetzbaren Typen enthalten im allgemeinen Polysiloxane mit Alkenylgruppen als Substituenten und solche mit an Silicium gebundenen Wasserstoffatomen. Sie werden in Gegenwart von Platinkatalysatoren bei Temperaturen oberhalb 50° C vernetzt. Sie haben den Vorteil, daß sie bei höherer Temperatur, z. B. um 100° C, schnell vernetzen. Dafür kann auch die Verarbeitungsdauer (Topfzeit) dieser Systeme relativ kurz sein. Es können auch Gemische von Einkomponenten- und Mehrkomponenten-, z. B. Zweikomponenten-Silikonkautschuken, eingesetzt werden.

Die durch Kondensation vernetzbaren Gemische enthalten Diorganopolysiloxane mit reaktionsfähigen Endgruppen, z. B. OH-Gruppen. Diese werden mit reaktiven Silanen oder Oligosiloxanen, z. B. Alkoxy- oder Acetoxysilanen oder Siloxanen, die mehrere Si-H-Gruppen im Molekül enthalten, in Gegenwart von Katalysatoren, wie Organozinnverbindungen, z. B. Dialkylzinndiacetat, vernetzt. Auch diese Kombinationen reagieren relativ schnell und haben deshalb eine begrenzte Topfzeit.

Mit besonderem Vorteil werden durch Kondensation vernetzbare Mehrkomponenten-Silikonkautschuke eingesetzt. Als Vernetzer sind im Prinzip alle reaktiven Alkoxy- und Acetoxysilane geeignet. Das Vernetzungsmittel beeinflußt aber die Haftung der lichtempfindlichen Schicht auf der Silikonkautschukschicht mit Zwischenschicht. Bevorzugte Vernetzer sind Silane, die Aminoalkyl- oder Epoxyalkylgruppen tragen.

Die gleichzeitige Verwendung mehrerer Silane kann günstig sein. Gut bewährt haben sich z. B. Gemische von Vinyl-triacetoxy-silan mit 3-Glycidyloxypropyl-trimethoxy-silan.

Die Konzentration des Vernetzers oder des Vernetzer-Gemisches beträgt üblicherweise 1 - 40 % der Polysiloxanmenge, vorzugsweise 2 - 20 %. Die Katalysatormenge liegt vorzugsweise bei etwa 2 bis 10 Gew.-%, z. B. 5 %, des Polysiloxananteils.

Die Silikonkautschukschichten können verstärkende Füllstoffe, wie hochdisperse Kieselsäure, enthalten. Auch andere feinteilige Pulver aus z. B. Polytetrafluorethylen oder Graphitfluorid können zugefügt werden. Die feinpulvrigen Materialien erleichtern in Konzentrationen, bei denen die Abhäsivität noch nicht vermindert wird, in der Regel die Verankerung der Haft- und Kopierschichten. Ähnliche Effekte erzielt man auch mit in der Silikonkautschuklösung löslichen Stoffen niedriger Oberflächenspannung, z. B. mit Polyethylenwachsen.

Da die Silikongummischicht nicht am Entwicklungsprozeß teilnimmt, ist ihre Dicke unkritisch. Aus wirtschaftlichen Gründen macht man sie nur so dick, daß sie den Druckvorgang gut aushält. Dicke Schichten sind auch ungünstig, wenn die aufzubringenden lichtempfindlichen Schichten geringe Flexibilität besitzen. Mit steigender Dicke der Silikonschicht nimmt die Gefahr der Rißbildung in der lichtempfindlichen Schicht zu. Üblicherweise liegt das Schichtgewicht etwa bei 1 - 100 g/m², vorzugsweise bei 3 - 10 g/m².

Die unvernetzte, lufttrockene Silikonkautschukschicht kann auf zwei Wegen mit einer Haftvermittlerschicht überzogen werden. Eine Möglichkeit besteht im Aufstreichen eines Kieselsäuresols und nachfolgendem Trocknen des Naßfilmes unter Ausbildung einer Schicht aus amorpher Kieselsäure. Entsprechende Haftschichten sind bereits zur Verankerung von Silikongummischichten auf handelsüblichen Naßoffsetdruckplatten in der deutschen Patentanmeldung P 36 28 719 vorgeschlagen worden. Nach der zweiten Methode erhält man Haftschichten durch Auftragen von Lösungen von lichtempfindlichen Halogenverbindungen auf die Silikonkautschukschicht und nachfolgende Belichtung der getrockneten Schicht mit aktinischem Licht.

Zur Herstellung der Kieselsäurehaftschicht streicht man auf die unvernetzte Silikonschicht wäßrige oder wäßrigalkoholische Kieselsäuresole auf und trocknet dann. Die beste Wirkung erzielt man mit alkalisch stabilisierten Kieselsäuresolen, bei denen die Teilchen größer als 20 nm, vorzugsweise 20 - 130 nm groß sind.

Zur besseren Benetzung der lichtempfindlichen Schicht wird dem Sol vorteilhaft eine kleine Menge eines wasserlöslichen Netzmittels, insbesondere eines anionischen oder nichtionischen Netzmittels zugesetzt. Geeignet sind z. B. Alkalisalze von langkettigen Alkansäuren, Alkylsulfonsäuren, Monoalkylsulfaten, Alkylbenzolsulfonsäuren und Polyalkoxyphenolether. Da die Netzmittel selbst einer guten Haftung entgegenwirken, sollte vorzugsweise die Menge an Netzmittel möglichst niedrig gehalten werden. Im allgemeinen werden Mengen von 1 bis 15, vorzugsweise 1 bis 10 und insbesondere 1 bis 5 Gew.-%, bezogen auf die Kieselsäuremenge, eingesetzt. Es ist vorteilhaft, Netzmittel einzusetzen, die die Oberflächenspannung der Kieselsäuresole besonders stark herabsetzen.

Die Oberflächenspannung der Kieselsäuresole kann auch durch Abmischen mit wasserlöslichen organischen Lösemitteln herabgesetzt werden. Netzmittel und Lösemittel können den Kieselsäuresolen auch gleichzeitig zugesetzt werden.

Die Konzentration des Kieselsäuresols wird so gewählt, daß die Kieselsäure/Netzmittel-Schicht nach dem Trocknen ein Gewicht von 0,01 - 1,0 g/m², vorzugsweise 0,1 - 0,5 g/m² besitzt. Üblicherweise verwendet man Streichlösungen, die etwa 1 % feste Kieselsäure enthalten.

Die Kieselsäuresole können wasserlösliche oder wasserdispergierbare Bindemittel enthalten, die beim Trocknen unlöslich werden. Bewährt haben sich wäßrige Lösungen und Dispersionen von Acrylharzen. Das Verhältnis von fester Kieselsäure zu Bindemittel kann 10 : 1 bis 1 : 50, vorzugsweise 1 : 1 bis 1 : 10 betragen.

Die Kieselsäureteilchen verankern sich vermutlich durch eine chemische Reaktion auf der Silikonkautschukschicht. Es wird angenommen, daß eine Kondensationsreaktion eintritt zwischen den an der Oberfläche der Kieselsäureteilchen liegenden Hydroxylgruppen und den Hydroxylgruppen der hochmolekularen unvernetzten Polysiloxane.

Haftschichten auf Basis lichtempfindlicher Halogenverbindungen erhält man durch Auftragen einer Lösung der Substanzen in einem organischen Lösemittel auf die unvernetzte Silikonkautschukschicht, Trocknen des Naßfilms und Belichten mit aktinischem Licht.

Als lichtempfindliche Halogenverbindungen verwendet man Verbindungen mit halogenierten Methylgruppen, insbesondere Trihalogenmethylgruppen. Es kann sich dabei um einfache Verbindungen wie Jodoform handeln. Vorzugsweise verwendet man jedoch nichtflüchtige Stoffe, z. B. substituierte Trichlormethyl-triazine, wie sie in der DE-C 27 18 259 und der EP-A 137 452 beschrieben sind. Auch andere mit Trichlormethylgruppen substituierte Heterocyclen sind geeignet.

Die lichtempfindlichen Stoffe oder Stoffgemische werden erst bei Belichtung mit UV-Licht auf der Silikonkautschukschicht fest verankert. Der Verankerungsmechanismus ist noch ungeklärt. Die Belichtung kann mit den gleichen Lampen erfolgen, die für den Kopiervorgang verwendet werden.

Damit die gebildete Haftschicht beim Entwicklungsvorgang mit den löslichen Teilen der bildmäßig belichteten lichtempfindlichen Schicht entfernt werden kann, sollte sie nicht dicker als etwa 1μm sein.

Zur Verankerung der lichtempfindlichen Schicht auf der Silikonkautschukschicht kann man auch beide Arten von Haftschichten zusammen einsetzen. Eine Doppelschicht aus untenliegender Kieselsäureschicht und obenliegender, belichteter Schicht aus lichtempfindlichen Halogenverbindungen bewirkt in der Regel eine stärkere Haftung als die Kieselsäureschicht allein.

Nach dem Aufbringen der Haftschicht und vor dem Auftragen der lichtempfindlichen Schicht ist es ratsam, die Silikonkautschukschicht durch kurzes Erwärmen (z. B. 10 - 60 s auf 110° C) teilweise zu vulkanisieren. Ohne diesen Schritt zeigen die lichtempfindlichen Schichten etwas geringere Haftung. Das führt beim Kopierprozeß zu etwas verminderter Bildqualität. Andererseits erschwert eine vollständige Vulkanisation vor dem Aufbringen der lichtempfindlichen Schicht die völlige Entfernung der Haftschicht an den Nichtbildstellen beim Entwicklungsvorgang.

Zur Herstellung der lichtempfindlichen Schicht beschichtet man die haftvermittelte Silikonschicht mit bekannten Beschichtungslösungen. Sowohl positiv arbeitende als auch negativ arbeitende Schichten können aufgebracht werden. Die Lösungen enthalten neben der lichtempfindlichen Substanz und einem geeigneten Lösemittel meist filmbildende Bindemittel, Sensibilisatoren, Stabilisatoren usw.

Als lichtempfindliche Substanzen in Negativkopierschichten können Diazoverbindungen, z. B. p-Diazodiphenylaminderivate und p-Chinondiazide, organische Azide, Polyvinylcinnamate, Polyvinylcinnamyliden-Verbindungen, Homo- oder Copolymere von Cinnamoyloxyethylacrylat oder -methacrylat verwendet werden. Außerdem können photopolymerisierbare Gemische aus Monomeren und Photoinitiatoren eingesetzt werden.

Beispiele für lichtempfindliche Materialien für Negativkopierschichten sind in den US-Patentschriften 2 649 373, 2 714 066, 3 751 257, 2 754 209, 2 975 053, 2 994 608, 2 995 442 und 3 209 146 angegeben.

Als lichtempfindliche Substanzen für Positivschichten verwendet man z. B. o-Chinondiazide oder Salze von p-Diazodiphenylamin mit Heteropolysäuren. Beispiele für 1,2-Chinondiazide sind in den US-Patentschriften 2 772 972, 2 767 092, 2 766 118, 2 859 112, 2 907 655, 3 046 110, 3 046 121, 3 061 430 und 3 106 465 angegeben.

Bevorzugte 1,2-Chinondiazide sind Ester von 1,2-Naphthochinon-2-diazid-4-sulfonsäure oder 1,2-Naphthochinon-2-diazid-5-sulfonsäure mit polymeren Phenolen, die durch Umsetzung von mehrwertigen Phenolen mit Ketonen erhalten werden. Das polymere Phenol besteht vorzugsweise aus einem durch Umsetzung von Aceton mit Pyrogallol bei Raumtemperatur in Gegenwart eines Katalysators, wie Phosphoroxychlorid, erhaltenen Produkt. Das Äquivalentverhältnis von Sulfonsäure zu polymerem Phenol kann im Bereich von 1 : 0,6 bis 1 : 2, bevorzugt von 1 : 1 bis 1 : 1,8 liegen.

Damit die Beschichtungslösungen die haftvermittelte, anvernetzte Silikonkautschukschicht gut benetzen, setzt man ihnen 0,01 bis 2 %, vorzugsweise 0,1 bis 1 % eines Polysiloxans oder Netzmittels zu. Geeignete Polysiloxane sind handelsübliche Silikonöle, Silikonverlaufmittel und Polysiloxanone, wie sie zur Herstellung von Silikongummi verwendet werden. Bevorzugte Netzmittel sind z. B. die Fluortenside.

Zur Verbesserung der Schichthaftung kann die Beschichtungslösung zusätzliche Bindemittel enthalten, z. B. in organischen Lösungsmitteln lösliche Vinylchlorid-Vinylacetat-Copolymerisate.

Nach Aufbringen der lichtempfindlichen Schicht wird das Material wenige Minuten auf 100 - 120° C erwärmt, bis die Silikongummischicht ausreichend vernetzt ist.

Als Schichtträger werden meist Metalle verwendet. Für Offsetdruckplatten können eingesetzt werden: walzblankes, mechanisch oder elektrochemisch aufgerauhtes und gegebenenfalls anodisiertes Aluminium, das zudem noch chemisch, z. B. mit Polyvinylphosphonsäure, Silikaten, Phosphaten, Hexafluorozirkonaten oder mit hydrolysiertem Tetraethylorthosilikat, vorbehandelt sein kann. Weitere geeignete Metalle sind Stahl und Chrom. Da im Gegensatz zu üblichen Flachdruckplatten die Trägeroberfläche nicht am Druckvorgang teilnimmt, können im Prinzip beliebige Substanzen als Trägeroberfläche dienen. Die Trägeroberfläche kann auch eine Haftvermittlerschicht tragen. Bei stark reflektierenden Trägeroberflächen kann eine Lichthofschutzschicht (Antihaloschicht) vorgesehen werden. Ferner können Kunststofffolien, wie Polyester-, Polycarbonat-, Polyimid-, Polyethersulfon-, Polytetrafluorethylen- oder auch Celluloseacetatfolien verwendet werden, deren Oberfläche ggf. zur Erhöhung der Haftung der Silikonkautschukschicht aufgerauht oder anderweitig vorbehandelt sein kann. Weiterhin sind bekannte Druckplattenträger aus Papier geeignet, das hier nicht naßfest zu sein braucht. Auch gummielastische Trägermaterialien sind geeignet.

Aus dem vorsensibilisierten Material erhält man eine druckfertige Flachdruckform durch Belichten unter einer Filmvorlage und durch Entwickeln. Zur Belichtung eignen sich z. B. Quecksilberdampfhochdrucklampen, Kohlenbogenlampen, Metallhalogenidlampen, Xenonimpulslampen, Leuchtröhrengeräte, Lasergeräte, Elektronenstrahlröhren und andere bekannte Belichtungsgeräte.

Beim Entwicklungsvorgang werden die leichter löslichen Partien der strahlungsempfindlichen Schicht und die darunterliegenden Bereiche der Zwischenschicht gelöst bzw. entfernt. Dabei wird die Oberfläche der Silikongummischicht freigelegt. Als Entwickler sind handelsübliche, den lichtempfindlichen Schichten angepaßte Lösungen, insbesondere wäßrige Lösungen, geeignet. Bei der Entwicklung muß die Zwischenschicht an den bildfreien Stellen völlig entfernt werden. Reste dieser Schicht führen beim Druck zum Tonen. Zur Entfernung der Kieselsäurehaftschicht eignen sich stark basische Entwickler besonders gut. Die freigelegte Oberfläche stößt Druckfarbe ab, während die erhalten gebliebenen Bereiche der lichtempfindlichen Schicht die Farbe annehmen. Das Einfärben der entwickelten Platte kann in oder außerhalb der Druckmaschine erfolgen.

Die Auflage kann bei Platten mit Positivkopierschichten aus o-Chinondiazid und Novolaken durch mehrere Minuten dauerndes Erwärmen der fertigen Druckform auf Temperaturen von 200 - 240 C stark erhöht werden. Beim Erwärmen nimmt die Haftung des Bildes auf der abhäsiven Silikonschicht stark zu. Gleichzeitig wird das Bild abriebfester. Nacherhitzte Platten können deshalb zur sicheren Entfernung von Resten der Kieselsäurehaftschicht noch einmal intensiv mit verdünnten Laugen oder basischen Entwicklern behandelt werden, ohne daß dabei das Bild beschädigt wird.

Die Erfindung wird im einzelnen anhand der nachfolgenden Beispiele erläutert. Gewichtsteile (Gt) und Volumteile (Vt) stehen im Verhältnis von g zu ml. Mengenverhältnisse und Prozentangaben sind, wenn nichts anderes vermerkt ist, in Gewichtseinheiten zu verstehen.

Beispiel 1
_____

Eine elektrolytisch aufgerauhte und anodisierte Aluminiumplatte wurde mit Hilfe einer Plattenschleuder (160 U/Minute) mit folgender Silikonkautschuklösung beschichtet:

84 Gt aliphatisches Kohlenwasserstoffgemisch, Siedebereich 116 - 142 C,
15 Gt einer 33 %igen Lösung eines Dihydroxypolydimethylsiloxans in Toluol, Viskosität bei 25 C = 9.000 bis 15.000 mPa·s,
0,5 Gt Vinyl-triacetoxysilan,
0,5 Gt Dibutylzinndiacetat.
0,5 Gt 3-Glycidyloxypropyl-trimethoxy-silan

Die Schicht wurde getrocknet und im im wesentlichen unvernetzten Zustand mit der folgendn Haftschichtlösung überschichtet und getrocknet:
74,5 Vt entsalztes Wasser,
20 Vt Isopropanol,
4 Vt 30 %iges anionisches Kieselsäuresol mit einem Na$_2$O-Gehalt von ca. 0,15 % und einer Teilchengröße von 25 - 30 nm und
1,5 Vt einer 1%igen Lösung von Nonylphenolpolyglykolether im entsalzten Wasser.

Nach Trocknen der Haftschicht mit Warmluft wurde die Silikonkautschukschicht durch 1 Minute Erwärmen auf 110 C unvollständig vulkanisiert.

Anschließend wurde eine filtrierte Lösung von
1,8 Gt des unten beschriebenen Naphthochinondiazidsulfonsäureesters,
0,22 Gt 1,2-Naphthochinon-2-diazid-4-sulfonylchlorid,
0,07 Gt 2,3,4-Trihydroxy-benzophenon,
6,6 Gt eines Kresol-Formaldehyd-Novolaks mit einem Schmelzbereich von 105 - 120 C nach DIN 53181,
0,08 Gt Kristallviolett und
0,4 Gt eines Fluortensids (Veresterungsprodukt aus einem Polyglykol mit Oxyethylen- und Oxypropyleneinheiten und einer Perfluoralkansäure) in
91,22 Gt eines Gemischs aus 5 Vt Tetrahydrofuran, 4 Vt Ethylenglykolmonomethylether und 1 Vt Butylacetat und
75,0 Gt Isopropanol
durch Schleudern aufgebracht und getrocknet.

Der in der obigen Rezeptur verwendete Naphthochinondiazidsulfonsäureester wurde wie folgt hergestellt:
Eine Lösung von 25,5 Gt 1,2-Naphthochinon-2-diazid-5-sulfonsäurechlorid in 442 Gt Aceton wurde über Aktivkohle geklärt. In der Lösung wurden 26,3 Gt des oben angegebenen Kresol-Formaldehyd-Novolaks und 4,4 Gt 2,3,4-Trihydroxy-benzophenon gelöst und das Ganze mit einer Lösung von 11,9 Gt NaHCO$_3$ in 124 Gt Wasser und mit 160 Gt gesättigter Natriumchloridlösung versetzt. Das Gemisch wurde 10 Minuten gerührt, absitzen gelassen, die untere Phase verworfen und die Acetonlösung innerhalb weniger Minuten in eine Lösung aus 6 Gt HCl (30 %) und 1500 Gt Wasser einfließen gelassen. Das ausgeschiedene gelbe flockige Reaktionsprodukt wurde abgesaugt, mit Wasser ausgewaschen und getrocknet. Die Ausbeute betrug 48 Gt.

Nach Trocknen der lichtempfindlichen Schicht wurde die Silikonschicht durch 3 Minuten Erwärmen auf 110° C vollständig vulkanisiert.

Die so gewonnene vorsensibilisierte Druckplatte wurde unter einer Positiv-Filmvorlage (60er Raster) 25 s mit einer 5 kW-Metallhalogenid-Lampe im Abstand von 120 cm belichtet und danach vorsichtig entwickelt. Dabei lösten sich die lichtempfindliche Schicht und die Kieselsäureschicht an den belichteten Stellen ab. Der verwendete Entwickler bestand aus einer wäßrigen Lösung von 10 Gew.-% Natriummetasilikat x 9 H$_2$O.

Nach Abspülen der Entwicklerflüssigkeit mit Wasser wurde die Platte 5 Minuten auf 230° C erwärmt und dann mit einem mit Lauge befeuchteten Wattebausch abgerieben. Als Lauge diente eine Lösung von 0,4 Gt NaOH in 50 Vt Wasser und 50 Vt Isopropanol.

Auf einer Offsetdruckmaschine, aus der das Feuchtwerk entfernt worden war, lieferte die so erhaltene Platte 10.000 gute Abzüge, ehe die feinsten Rasterpunkte ausbrachen. Eine unter gleichen Bedingungen hergestellte, nicht nacherwärmte Platte zeigte beim Druckvorgang schon nach einigen 100 Drucken abnehmende Bildqualität. Bei Herstellung der Platte ohne die Haftschicht wurde das Bild infolge ungenügender Haftung schon beim Entwickeln beschädigt.

Beispiel 2

Beispiel 1 wurde wiederholt, zur Herstellung der Silikongummischicht aber folgendes Gemisch aus RTV-1- und RTV-2-Silikonkautschuk verwendet:
84 Gt Kohlenwasserstoffgemisch wie in Beispiel 1,
7,5 Gt der in Beispiel 1 genannten Dihydroxy-polydimethylsiloxan-Lösung,
0,25 Gt Vinyl-triacetoxy-silan,
0,25 Gt 3-Glycidyloxy-propyl-trimethoxy-silan,
0,15 Gt Dibutylzinndiacetat,
7,5 Gt einer 40 %igen toluolischen Lösung eines füllstoffhaltigen Einkomponentensilikonkautschuks vom Essigsäuretyp mit einer Viskosität von ca. 250 mPa•s (23° C).

Auf der Offsetdruckmaschine (ohne Wasser) konnten mit der fertigen Druckform über 10.000 Abzüge hergestellt werden, ehe die Bildqualität abnahm.

Beispiel 3

Beispiel 2 wurde wiederholt, wobei anstelle der verwendeten 7,5 Gt Silikonkautschuklösung die folgende Mischung verwendet wurde:
6,25 Gt einer 80 %igen toluolischen Lösung eines füllstoffhaltigen Einkomponentensilikonkautschuks vom Essigsäuretyp mit einer Viskosität von ca. 65.000 bei 23° C,
3,75 Gt Kohlenwasserstoffgemisch wie in Beispiel 1.

Auf der Offsetdruckmaschine wurden mit der Platte über 5.000 Drucke gefertigt.

Beispiel 4

Auf eine nach Beispiel 1 hergestellte, unvernetzte Silikonkautschukschicht wurde zur Erzeugung eines Haftgrundes folgende Lösung aufgeschleudert (160 U/Minute):
0,3 Gt 2-(4-Styryl-phenyl)-4,6-bis-trichlormethyl-s-triazin,
0,2 Gt Fluortensid wie in Beispiel 1,
100 Vt Toluol.

Anschließend wurde das Material 1 Minute auf 110° C erwärmt und dann in einem Röhrenbelichtungsgerät (120 W) 3 Minuten ohne Vorlage belichtet. Das Auftragen der lichtempfindlichen Schicht, die Ausvulkanisation der Silikongummischicht und die Verarbeitung zur gebrauchsfertigen Druckform erfolgte nach den Angaben von Beispiel 1. Auf die Nachbehandlung mit wäßrig/alkoholischer Natronlauge wurde verzichtet.

Auf einer Offsetdruckmaschine lieferte die Platte bei Verwendung einer Trockenoffsetdruckfarbe 40.000 gute Drucke.

Beispiel 5

Beispiel 4 wurde wiederholt, jedoch wurde anstelle des dort genannten Trichlormethyl-triazins das 2-(4-Ethoxynaphth-1-yl)-4,6-bis-trichlormethyl-s-triazin verwendet.

Auf einer Kleinoffsetdruckmaschine (ohne Feuchtwerk) konnten mit der hergestellten Druckform mehr als 11.000 gute Abzüge gewonnen werden.

Beispiel 6

Eine elektrolytisch aufgerauhte und anodisierte Aluminiumplatte wurde nach den Angaben in Beispiel 1 nacheinander mit einer Silikonkautschukschicht und einer Kieselsäurehaftschicht beschichtet. Danach wurde folgende Lösung aufgeschleudert:
0,25 Gt des in Beispiel 5 angegebenen Trichlormethyltriazins,
0,2 Gt Fluortensid wie in Beispiel 1,
100 Vt Toluol.

Das Material wurde 1 Minute auf 110° C erwärmt und 3 Minuten ohne Vorlage in einem Röhrenbelichtungsgerät (120 W) belichtet, dann nach den Angaben in Beispiel 1 mit einer lichtempfindlichen Schicht versehen und ausvulkanisiert.

Die Umwandlung der vorsensibilisierten Druckplatte in eine fertige Druckform erfolgte ebenfalls nach den Angaben von Beispiel 1.

Auf einer Kleinoffsetdruckmaschine ohne Feuchtwerk lieferte die Platte 8.000 gute Drucke.

Durch Zugabe von 0,5 % eines handelsüblichen Copolymerisats aus Vinylchlorid, Vinylacetat und 1 % Maleinsäure zu der Beschichtungslösung konnte die Auflage noch weiter gesteigert werden.

Beispiel 7

In der in Beispiel 1 beschriebenen Silikonkautschuklösung wurde das verwendete Kohlenwasserstoffgemisch ausgetauscht gegen Toluol, das vorher mit unpolarem Polyethylenwachs (Tropfpunkt 118 - 123° C) gesättigt worden war. Die Lösung wurde auf eine elektrolytisch aufgerauhte und anodisierte Aluminiumfolie aufgeschleudert. Die getrocknete Schicht wurde mit folgender Lösung überschichtet:
0,3 Gt des in Beispiel 5 angegebenen Triazins,
0,2 Gt Fluortensid wie in Beispiel 1,
100 Vt Toluol.

Nach 1 Minute Erwärmen auf 110° C und 3 Minuten Belichten in einem Röhrenbelichtungsgerät (120 W) wurde das Material nach den Angaben in Beispiel 1 mit einer lichtempfindlichen Schicht versehen und zu einer gebrauchsfertigen Druckform weiterverarbeitet. Die nicht nacherwärmte Druckform lieferte in einer Kleinoffsetdruckmaschine (ohne Feuchtwerk) 2.000 gute Drucke.

Beispiel 8

Eine anodisierte Aluminiumfolie wurde nach Beispiel 1 mit einer Silikonkautschukschicht und nach Beispiel 4 mit einer Haftschicht versehen. Danach wurde folgende Lösung aufgeschleudert und getrocknet:
1.2 Gt des Veresterungsproduktes aus 1 mol 2,3,4-Trihydroxy-benzophenon und 2 mol 1,2-Naphthochinon-2-diazid-5-sulfonsäurechlorid,
0,7 Gt des Veresterungsproduktes aus 1 mol 2,2′-Dihydroxy-dinaphthyl-(1,1′)-methan und 2 mol 1,2-Naphthochinon-2-diazid-5-sulfonsäurechlorid,
6,5 Gt des in Beispiel 1 angegebenen Novolaks und
0,05 Gt Sudangelb GGN (C.I. 11021)
in einem Lösungsmittelgemisch aus
40 Gt 2-Methoxy-ethanol,
50 Gt Tetrahydrofuran und

8 Gt Butylacetat.

Das Material wurde 3 Minuten auf 110° C erwärmt und dann in einem 120 W-Röhrenbelichtungsgerät unter einer positiven Filmvorlage (60er Raster) 2,5 Minuten lang belichtet und anschließend mit dem in Beispiel 1 angegebenen Entwickler entwickelt.

Auf einer Kleinoffsetmaschine wurden mit der gefertigten Druckform 1.500 gute Drucke erhalten. Wurde die Druckform vor ihrer Verwendung 5 Minuten auf 230° C erwärmt, so lieferte sie ca. 5.000 Drucke. Eine Vergleichsplatte ohne Haftschicht ließ sich nicht fehlerfrei entwickeln.

Beispiel 9

Eine elektrolytisch aufgerauhte Aluminiumfolie wurde auf einer Plattenschleuder (160 U/Minute) mit folgender Silikonkautschuklösung beschichtet:
84 Gt Kohlenwasserstoffgemisch wie im Beispiel 1,
15 Gt der in Beispiel 1 genannten Dihydroxypolydimethylsiloxan-Lösung,
1 Gt Vinyl-triacetoxy-silan,
0,3 Gt Dibutylzinndiacetat.

Nach dem Abtrocknen mit Warmluft wurde nachstehende Haftschichtlösung aufgeschleudert:
57 Vt entsalztes Wasser,
38 Vt Isopropanol,
3 Vt einer 40 %igen, zinksalzhaltigen, wäßrigen Lösung eines Acrylsäure-Copolymeren mit einem pH-Wert von ca. 7,5 - 8,0 (Primal B-505),
2 Vt des in Beispiel 1 genannten Kieselsäuresols.

Anschließend wurde die Silikonschicht durch 4 Minuten Erwärmen auf 110° C vernetzt und dann folgende Kopierlösung aufgeschleudert:
1,59 Gt des Polykondensationsprodukts aus 1 mol> 3-Methoxy-diphenylamin-4-diazoniumsalz und 1 mol 4,4′-Bis-methoxymethyl-diphenylether, ausgefällt als Mesitylensulfonat,
0,17 Gt Phosphorsäure (85 %),
0,31 Gt Viktoriareinblau FGA (C.I. 42 595),
0,2 Gt des in Beispiel 1 angegebenen Fluortensids,
70 Vt Butanon,
30 Vt 2-Methoxyethanol.

Nach 1 Minute Trocknen bei 110° C wurde das Material unter einer Negativfilmvorlage (60er Raster) nach den Angaben in Beispiel 1 belichtet und dann mit einer Lösung von
5 Gt Natriumundecanoat,
3 Gt eines Block-Copolymerisats aus 80 % Propylenoxid und 20 % Ethylenoxid und
3 Gt Tetranatriumdiphosphat in
89 Gt entsalztem Wasser
entwickelt. Die Platte wurde 5 Minuten auf 230° C erhitzt und schließlich mit 1 %iger, wäßriger Alkalilauge abgewischt.

In einer Offsetdruckmaschine ohne Feuchtwerk wurden mit der Platte 2.000 Drucke erhalten, ehe die feinsten Rasterpunkte auszubrechen begannen. Bei Verzicht auf die Nacherwärmung lag die Druckauflage ähnlich hoch, die Platte zeigte jedoch deutliche Neigung zum Tonen. Beim Versuch, die Platte ohne Haftschicht herzustellen, konnten keine fehlerfreie Bilder entwickelt werden.

Beispiel 10

Eine elektrolytisch aufgerauhte Aluminiumfolie wurde wie in Beispiel 9 mit einer unvernetzten Silikongummischicht überzogen und dann mit nachstehender Haftlösung beschichtet:
76,1 Vt entsalztes Wasser,
20 Vt Isopropanol,
2,4 Vt 50 %iges wäßriges Kieselsäuresol mit einem $Na_2O$-Gehalt von 0,2 % und einer mittleren Teilchengröße von 125 nm,
1,5 Vt 1 %ige Lösung von Nonylphenolpolyglykolether in entsalztem Wasser.
Auf die getrocknete Schicht wurde die folgende Lösung aufgeschleudert und getrocknet:
62 Gt eines Umsetzungsprodukts aus 50 Gt eines Polyvinylbutyrals mit 71 % Vinylbutyral-, 2 % Vinylacetat- und 27 % Vinylalkoholeinheiten und 4 Gt Maleinsäureanhydrid,
21 Gt des in Beispiel 9 angegebenen Diazoniumsalz-Polykondensationsprodukts,
2,5 Gt Phosphorsäure (85 %),
3 Gt Victoriareinblau FGA,
0,7 Gt Phenylazodiphenylamin und
17 Gt einer 50 %igen Lösung eines lackverträglichen Siloxancopolymeren in Xylol/Isobutanol 4:1 in 2570 Gt 2-Methoxy-ethanol und
780 Gt Tetrahydrofuran.
Nach Vulkanisation der Silikonschicht durch 4 Minuten Erwärmen auf 110° C wurde das Material unter einer Negativfilmvorlage (60er Raster) in einem 120 W-Röhrenbelichtungsgerät 1 Minute belichtet und die unbelichteten Stellen dann mit dem folgenden Entwickler abgelöst:
3 Gt 2-Phenoxy-ethanol,
2 Gt Graham'sches Salz,
2 Gt Polyvinylmethylacetamid,
4 Gt Pelargonsäure,
1 Gt KOH,
3 Gt Triethanolamin,
77 Gt entsalztes Wasser.
Die hergestellte Druckform zeigte in einer Kleinoffsetdruckmaschine ohne Feuchtwerk erst nach 2.000 Drucken abnehmende Bildqualität. Wurde die Druckform vor ihrer Verwendung 5 Minuten auf 150° C erwärmt, dann stieg die Druckauflage auf ca. 7.000.
Eine Vergleichsplatte ohne Haftschicht ließ sich nicht ohne Schädigung des Rasterbildes entwickeln. Bei Verwendung einer Strichvorlage war die Bildentwicklung zwar möglich, beim Druckvorgang lief das Bild aber nach einigen 100 Drucken ab.

Ansprüche

1. Vorsensibilisierte Druckplatte für den wasserlosen Flachdruck mit einem Schichtträger, einer darauf aufliegenden Druckfarbe abweisenden vernetzten Silikonkautschukschicht, einer Zwischenschicht und einer strahlungsempfindlichen Schicht, dadurch gekennzeichnet, daß die Zwischenschicht aus amorpher Kieselsäure oder aus einer belichteten Schicht einer lichtempfindlichen organischen Halogenverbindung besteht.

2. Druckplatte nach Anspruch 1, dadurch gekennzeichnet, daß die Zwischenschicht durch Auftragen und Trocknen eines wäßrigen, anionischen Kieselsäuresols erhalten worden ist.

3. Druckplatte nach Anspruch 2, dadurch gekennzeichnet, daß das Kieselsäuresol ein wasserlösliches Netzmittel enthält.

4. Druckplatte nach Anspruch 2, dadurch gekennzeichnet, daß das Kieselsäuresol eine Teilchengröße von mehr als 20 nm hat.

5. Druckplatte nach Anspruch 1, dadurch gekennzeichnet, daß die organische Halogenverbindung eine Trihalogenmethylgruppe enthält.

6. Druckplatte nach Anspruch 1, dadurch gekennzeichnet, daß die organische Halogenverbindung eine heterocyclische Verbindung mit mindestens einem Trichlormethylsubstituenten ist.

7. Druckplatte nach Anspruch 1, dadurch gekennzeichnet, daß die Zwischenschicht ein Flächengewicht von 0,01 bis 1 $g/m^2$ hat.

8. Druckplatte nach Anspruch 1, dadurch gekennzeichnet, daß sie je eine Zwischenschicht aus amorpher Kieselsäure und aus einer belichteten lichtempfindlichen organischen Halogenverbindung enthält.

9. Druckplatte nach Anspruch 1, dadurch gekennzeichnet, daß der Silikonkautschuk ein bei Raumtemperatur vernetzbarer Zweikomponentenkautschuk ist.

10. Druckplatte nach Anspruch 1, dadurch gekennzeichnet, daß die Silikonkautschukschicht ein Flächengewicht von 1 bis 50 $g/m^2$ hat.

11. Druckplatte nach Anspruch 1, dadurch gekennzeichnet, daß die strahlungsempfindliche Schicht ein Polysiloxan oder ein Netzmittel enthält.

12. Verfahren zur Herstellung einer vorsensibilisierten Druckplatte für den wasserlosen Flachdruck, dadurch gekennzeichnet, daß man auf einen Schichtträger eine Silikonkautschuklösung aufbringt und trocknet, auf die unvernetzte Silikonkautschukschicht nacheinander .eine Zwischenschicht aus amorpher Kieselsäure und eine strahlungsempfindliche Schicht aufbringt und danach die Silikonkautschukschicht zu Silikongummi vernetzt.

13. Verfahren zur Herstellung einer vorsensibilisierten Druckplatte für den wasserlosen Flachdruck, dadurch gekennzeichnet, daß man auf einen Schichtträger eine Silikonkautschuklösung aufbringt und trocknet, auf die unvernetzte Silikonkautschukschicht eine Zwischenschicht aus einer lichtempfindlichen organischen Halogenverbindung aufbringt, die Zwischenschicht mit aktinischem Licht ohne Vorlage belichtet, dann eine strahlungsempfindliche Schicht aufbringt und danach die Silikonkautschukschicht zu Silikongummi vernetzt.

14. Verfahren nach einem der Ansprüche 12 und 13, dadurch gekennzeichnet, daß man die Silikonkautschukschicht nach dem Aufbringen der Zwischenschicht und vor dem Aufbringen der lichtempfindlichen Schicht unvollständig vernetzt.